# EUROPEAN PATENT SPECIFICATION

(11) **EP 0 542 532 B1**
(45) Date of publication and mention of the grant of the patent: **13.03.1996**
(21) Application number: 92310310.5
(22) Date of filing: 12.11.1992
(51) Int. Cl.: H01L 23/057, H01L 23/367, H01L 23/64

(54) **Package structure of a semiconductor device having a built-in capacitor**
Packungsstruktur einer Halbleiteranordnung mit einem eingebauten Kondensator
Structure d'empaquetage d'un dispositif semi-conducteur avec un condensateur incorporé

(30) Priority: 15.11.1991 JP 326810/91
(43) Date of publication of application: 19.05.1993
(73) Proprietor: NEC CORPORATION, Tokyo (JP)
(72) Inventor: Mizunashi, Harumi, c/o NEC Corporation, Tokyo (JP)
(74) Representative: Moir, Michael Christopher

(56) References cited:
- EP-A- 0 180 219
- EP-A- 0 382 203
- PATENT ABSTRACTS OF JAPAN vol. 14, no. 408 (E-972) 4 September 1990 ; & JP-A-21 52 269

## Description

### Background of the Invention

The present invention relates to a semiconductor device and, more particularly, to a package structure of a semiconductor device obtained by arranging a semiconductor element on an insulating board from which external terminals extend.

In recent years, in addition to a high-speed operation, since a multifunction has been strongly demanded for a semiconductor element, the power consumption of the semiconductor element has been considerably increased. For this reason, the package structure of the semiconductor element suitable for a decrease in thermal resistance and a high-speed operation has been strongly demanded.

The decrease in thermal resistance is obtained as follows. That is, a distance between a semiconductor element and a main heat sink is decreased, and a material having a high thermal conductivity is selected as a material located between the semiconductor element and the main heat sink. The high-speed operation of a semiconductor element is achieved such that the resistance of a power supply line is decreased or that a distance between each electrode of the semiconductor element and the corresponding external lead of the package is minimized. Such a device is disclosed in EP-A-0.382.203.

As a package structure of a semiconductor element coping with the above demands, a first prior art called a C/D (cavity down) structure and a second prior art called an FTC (Flipped Tub Carrier) structure are known to the applicant.

According to the first prior art, external leads are arranged at the peripheral portion of a package surface on which a semiconductor element is formed, and the semiconductor element is arranged at the center of the package. In this case, a heat sink means is obtained such that a metal or ceramic plate having a high thermal conductivity is bonded to the lower surface of the semiconductor element, and the resultant body is mounted on a heat sink.

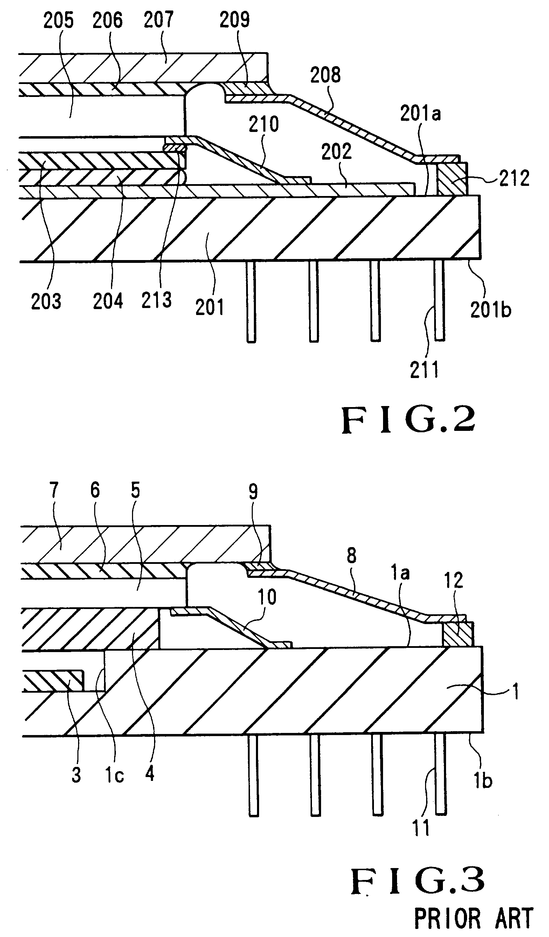

On the other hand, according to the second prior art, as shown in the sectional view of Fig. 3, leads 10 are connected to the electrodes of a semiconductor element 5, and the leads 10 are connected to the electrode terminals of a ceramic wiring board 1 having a required wiring pattern formed in and on its surface. In this case, the semiconductor element 5 is arranged such that its electrodes are opposite to the electrode terminals of the wiring board 1. A buffer member 4 is inserted between the semiconductor element 5 and the ceramic wiring board 1, and a bypass capacitor 3 for reducing noise of a power supply system is located in a recessed portion 1c of the ceramic wiring board 1 under the buffer member 4.

A wiring layer formed by screen printing is formed in the ceramic wiring board 1, and a wiring layer and electrode terminals formed by a thin-film technique are formed on an upper surface la of the board I to obtain a highly accurate pattern corresponding to a decrease in distance between the electrodes of the semiconductor element 5. In addition, external leads 11 are arranged on a lower surface 1b of the ceramic wiring board 1.

A metal plate 7 serving as a heat sink having a peripheral portion at which a metal frame 8 is brazed by a brazing material 9 is adhered to the lower surface of the semiconductor element 5 through an adhesive 6. The metal frame 8 is welded to a seal ring 12 arranged at the peripheral portion of the upper surface la of the ceramic wiring board 1.

In the above FTC structure of the semiconductor device, the "decrease in thermal resistance" is achieved as follows. For example, a heat sink is mounted on the metal plate 7 to forcibly perform air cooling, and heat generated by the semiconductor element 5 is dissipated through the adhesive 6 and the metal plate 7 which are arranged on the upper surface of the semiconductor element 5.

In addition, the "high-speed operation" is achieved by minimizing the overall length of wiring lines extending from the electrodes of the semiconductor element 5 to the external leads 11.

In addition, noise of the power supply system which becomes conspicuous in accordance with the high-speed operation can be reduced by the bypass capacitor 3. A power supply wiring layer in the board 1 has a plate-like shape to obtain a power supply wiring having a low resistance.

In the C/D structure of the first prior art, however, the surface of the ceramic wiring board from which external leads extend serves as the surface on which a semiconductor element is mounted, and the overall length of the wiring lines is increased to prevent the wiring lines from crossing each other. For this reason, the wiring lines between the electrodes of the semiconductor element and the external leads cannot easily be minimized. Therefore, the C/D structure does not sufficiently cope with a high-speed semiconductor element.

In addition, when a semiconductor element has a smaller size and a more advanced multifunction, a signal wiring must be a multilayered wiring. In the FTC structure of-the second prior art, since the wiring in the ceramic wiring board 1 is multilayered by a thick-film scheme, the wiring pattern cannot be accurately formed, and the wiring cannot be easily formed at a high density. For this reason, although the multilayered wiring must have a large number of layers, since each insulating film (ceramic) between the wiring layers has a large thickness of 50 to 100 µm or more, the thickness of the board is considerably increased, and the wiring length is disadvantageously increased accordingly.

When a higher-speed semiconductor element is obtained, a wiring pattern must be handled as a distributed constant circuit, and matching of characteristic impedances and the like must be considered. However, the second prior art cannot cope with these points because wiring layers other than the wiring layer on the surface of the board are formed by a thick-film technique.

For this reason, it is assumed that a thin-film multilayered wiring layer having a thin-film copper layer as a wiring layer and a polyimide layer as an insulating layer should be formed on a ceramic wiring board. In this case, however, since the insulating film is formed by spin coating, the thin-film multilayered wiring layer cannot be applied when a board surface has a recessed portion for incorporating a power noise reduction capacitor. When this power noise reduction capacitor is externally arranged, not only the effect of noise reduction is limited, but the externally arranged capacitor is against the recent important market need for the decrease in equipment size.

### Summary of the Invention

It is an object of the present invention to provide a semiconductor device capable of coping with a high-speed operation.

It is another object of the present invention to provide a compact, multifunctional semiconductor device.

It is still another object of the present invention to provide a semiconductor device in which a power noise reduction capacitor is incorporated.

In order to achieve the above objects, according to the present invention there is provided a semiconductor device comprising:
an insulating board having a first surface on which an external lead is arranged and a second surface on which a wiring layer is formed and is connected to the external lead via a through hole;
a multilayered wiring layer formed on the second surface of the insulating board and having an electrode terminal electrically connected to the wiring layer of the insulating board;
a semiconductor element arranged such that a first surface of the semiconductor element on which an electrode is formed faces the multilayered wiring layer, said electrode being connected to the multilayered wiring layer; and
a heat sink fixed on a second surface of the semiconductor element opposite to the first surface thereof, characterised by said device further comprising:
a power noise reduction capacitor formed on an alumina ceramic plate by a thin film technique and arranged between the multilayered wiring layer and the semiconductor element; and
a buffer member fixed on a surface of the power noise reduction capacitor to prevent the semiconductor element from being damaged by mechanical pressure when the heat sink is fixed on the semiconductor element.

### Brief Description of the Drawings

Fig. 1 is a sectional view showing the main part of a semiconductor device according to the first embodiment of the present invention;
Fig. 2 is a sectional view showing the main part of a semiconductor device according to the second embodiment of the present invention; and
Fig. 3 is a sectional view showing the main part of a conventional semiconductor device.

### Description of the Preferred Embodiments

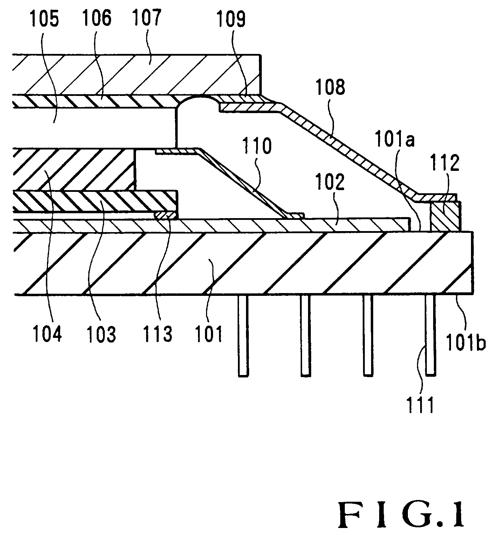

Fig. 1 shows the main part of a semiconductor device according to the first embodiment of the present invention. In Fig. 1, a ceramic wiring board 101 serves as an insulating board, external leads 111 extend on a lower surface 101b of-the ceramic wiring board 101, and a wiring layer (not shown) is formed on an upper surface 101a. In the ceramic wiring board 101, a wiring layer of a power supply system is formed like a plate, and a wiring layer (not shown) and through holes for connecting the external leads 111 to the wiring layer on the upper surface are formed. In addition, a multilayered wiring layer 102 having a polyimide layer as an insulating interlayer and a thin-film copper layer as a wiring layer is formed on the upper surface 101a of the ceramic wiring board 101. The polyimide layer of the multilayered wiring layer 102 is formed by patterning performed by spin coating, curing, and photolithographic steps, and the wiring layer is formed by sputtering of copper and a photolithographic technique. The electrode terminals (not shown) of the power supply system are arranged at the center of the multilayered wiring layer 102, a capacitor 103 for reducing noise of the power supply system is connected to the electrode terminals through an Sn/Pb-based brazing material 113. That is, the capacitor 103 is arranged such that its surface having electrodes (not shown) is opposite to the multilayered wiring layer 102, and each electrode of the capacitor 103 is connected to a corresponding one of the electrode terminals of the multilayered wiring layer 102 through the brazing material 113. A capacitor formed by a thin-film technique on an alumina ceramic plate having, e.g., a size of 10 mm × 10 mm and a thickness of 0.2 mm, is used as the capacitor 103.

A semiconductor element 105 is arranged on the capacitor 103 through a buffer material 104. The buffer material 104 having, e.g., a size of 8 mm × 8 mm and a thickness of 0.3 mm, and consisting of silicone rubber is adhered and fixed on the capacitor 103. The semiconductor element 105 is adhered and fixed on the buffer material 104 such that the electrodes of the semiconductor element 105 face downward to be opposite to the multilayered wiring layer 102. The electrodes of the semiconductor element 105 are respectively connected to electrode terminals formed on the surface of the multilayered wiring layer 102 through leads 110 using a TAB (Tape Automated Bonding) scheme. In this case, a semiconductor element having, e.g., a size of 12 mm × 12 mm, an inter-electrode distance of 80 µm, and 560 electrodes is used as the semiconductor element 105.

A metal plate 107 having a high thermal conductivity and serving as a heat sink is adhered and fixed by an adhesive 106 on the upper surface of the semiconductor element 105, i.e., on the surface opposite to the surface of the semiconductor element 105 on which the electrodes are formed. A metal frame 108 is brazed on the peripheral portion of the metal plate 107 by a brazing material 109 consisting of an Ag-Cu eutectic alloy. - As a material of the metal plate 107, for example, a material obtained by impregnating sintered tungsten with copper is used. A frame consisting of Kovar is used as the metal frame 108. The peripheral portion of the metal frame 108 is connected by seam welding to a seal ring 112 arranged at the peripheral portion of the upper surface 101a of the ceramic wiring board 101.

The purpose of arranging the buffer material 104 is as follows. That is, although a mechanical pressure must act on the metal plate 107 to adhere the metal plate 107 to the upper surface of the semiconductor element 105 by the adhesive 106 without any gap, the buffer material 104 prevents the semiconductor element 105 from being damaged by the pressure.

According to the first embodiment, the leads 110 connected to the electrode terminals of the multilayered wiring layer 102 are electrically connected to the external leads 111 through the wiring layer of the multilayered wiring layer 102, the wiring layer on the upper surface of the ceramic wiring board 101, and through holes.

Fig. 2 shows the main part of a semiconductor device according to the second embodiment of the present invention. This embodiment is different from the first embodiment in the following points. A buffer material 204 is directly arranged on a ceramic wiring board 201, a capacitor 203 is interposed between the buffer material 204 and a semiconductor element 205, and the capacitor 203 is arranged such that its surface having electrodes is opposite to the semiconductor element 205 to connect the electrodes to leads 210. Other arrangements are the same as those of the first embodiment.

In the second embodiment, although the capacitor 203 must be accurately arranged, this bypass capacitor can be advantageously arranged near the electrodes of the semiconductor element 205.

As described above, in the semiconductor device according to the present invention, a thin-film multilayered wiring layer is arranged on one smooth surface of an insulating board, a bypass capacitor is incorporated in a space formed between the board and a semiconductor element which are bonded to each other by a TAB scheme, and a metal plate is adhered to the upper surface of the semiconductor element. For this reason, the following effects can be obtained.
① Since the wiring layer is formed by a thin film, a highly accurate wiring layer in consideration of the characteristic impedance can be obtained.
② The multilayered wiring layer can have an accurate wiring pattern and a small total thickness,, and external leads are arranged at arbitrary positions, thereby decreasing a wiring distance between the electrodes of the semiconductor element and the external leads.
③ Since the bypass capacitor is incorporated, power supply noise can be suppressed, and the packing density of equipment can be increased.
④ Heat generated by the semiconductor element can be immediately transmitted to the metal plate.

According to the present invention, therefore, there can be provided a semiconductor device capable of sufficiently performing the functions of the semiconductor device to cope with the operation of a semiconductor element having a multifunction, a high-speed operation, and a high integration density.

## Claims

1. A semiconductor device comprising:
an insulating board (101,201) having a first surface (101b,201b) on which an external lead (111,211) is arranged and a second surface (101a,201a) on which a wiring layer is formed and is connected to the external lead via a through hole;
a multilayered wiring layer (102,202) formed on the second surface of the insulating board and having an electrode terminal electrically connected to the wiring layer of the insulating board;
a semiconductor element (105,205) arranged such that a first surface of the semiconductor element on which an electrode is formed faces the multilayered wiring layer, said electrode being connected to the multilayered wiring layer (102,202); and
a heat sink (107,207) fixed on a second surface of the semiconductor element opposite to the first surface thereof, characterised by said device further comprising:
a power noise reduction capacitor (103,203) formed on an alumina ceramic plate by a thin film technique and arranged between the multilayered wiring layer and the semiconductor element; and
a buffer member (104,204) fixed on a surface of the power noise reduction capacitor to prevent the semiconductor element from being damaged by mechanical pressure when the heat sink is fixed on the semiconductor element.

2. A device according to Claim 1, wherein said buffer member (104) is arranged between the capacitor and the semiconductor element.

3. A device according to Claim 1, wherein said buffer member (204) is arranged between the multilayered wiring layer and the capacitor.

4. A device according to Claim 1 or Claim 2, wherein the multilayered wiring layer has a surface on which a power supply electrode terminal is formed, the capacitor having a second surface opposite to the first-mentioned surface thereof on which an electrode is formed, said second surface of the capacitor facing the surface of the multilayered wiring layer, the electrode of the capacitor being connected to the power supply electrode terminal.

5. A device according to Claim 1 or Claim 3, wherein the capacitor has a second surface opposite to the first-mentioned surface thereof on which an electrode is formed, said second surface facing the first surface of the semiconductor element, the electrode of the capacitor being connected to the electrode of the semiconductor element.

6. A device according to any preceding claim, wherein the multilayered wiring layer is formed such that a polyimide layer and a thin metal film are used as an insulating layer and a conductive layer respectively.

## Patentansprüche

1. Halbleiterbauelement, das aufweist:
eine isolierende Platte (101,201) mit einer ersten Oberfläche (101b,201b), auf der eine äußere Anschlußleitung (111,211) angeordnet ist, und mit einer zweiten Oberfläche (101a,201a), auf der eine Verdrahtungsschicht ausgebildet ist und mit der externen Anschlußleitung über ein Durchgangsloch verbunden ist;
eine vielschichtige Verdrahtungsschicht (102,202), die auf der zweiten Oberfläche der isolierenden Platte ausgebildet ist und mit einem Elektrodenanschluß elektrisch mit der Verdrahtungsschicht der isolierenden Platte verbunden ist;
ein Halbleiterelement (105,205), das so angeordnet ist, daß eine erste Oberfläche des Halbleiterelementes, auf dem die Elektrode ausgebildet ist, zur vielschichtigen Verdrahtungsschicht gerichtet ist, wobei die Elektrode mit der vielschichtigen Verdrahtungsschicht (102,202) verbunden ist; und
einen Wärmeableiter (107,207), der auf einer zweiten Oberfläche des Halbleiterelementes gegenüber von dessen erster Oberfläche befestigt ist, dadurch gekennzeichnet, daß das Bauelement weiter aufweist:
einen Kondensator (103,203) zur Verringerung des Versorgungsspannungsrauschens, der auf einer keramischen Aluminiumoxidplatte durch eine Dünnschichttechnik ausgebildet ist und zwischen der vielschichtigen Verdrahtungsschicht und dem Halbleiterelement angeordnet ist; und
ein Pufferglied (104,204), das auf einer Oberfläche des Kondensators, der zur Verringerung des Versorgungsspannungsrauschens dient, befestigt ist, um zu verhindern, daß das Halbleiterelement durch mechanischen Druck beschädigt wird, wenn der Wärmeableiter an dem Halbleiterelement befestigt wird.

2. Bauelement nach Anspruch 1, bei dem das Pufferglied (104) zwischen dem Kondensator und dem Halbleiterelement angeordnet ist.

3. Bauelement nach Anspruch 1, bei dem das Pufferglied (204) zwischen der vielschichtigen Verdrahtungsschicht und dem Kondensator angeordnet ist.

4. Bauelement nach Anspruch 1 oder 2, bei dem die vielschichtige Verdrahtungsschicht eine Oberfläche hat, auf der ein Leistungsversorgungselektrodenanschluß ausgebildet ist, wobei der Kondensator eine zweite Oberfläche aufweist, die seiner erstgenannten Oberfläche gegenüberliegt, auf der eine Elektrode ausgebildet ist, wobei die zweite Oberfläche des Kondensators zur Oberfläche der vielschichtigen Verdrahtungsschicht gerichtet ist, wobei die Elektrode des Kondensators mit dem Leistungsversorgungselektrodenanschluß verbunden ist.

5. Bauelement nach Anspruch 1 oder 3, bei dem der Kondensator eine zweite Oberfläche hat, die seiner erstgenannten Oberfläche gegenübersteht, auf der eine Elektrode ausgebildet ist, wobei die zweite Oberfläche zur ersten Oberfläche des Halbleiterelements gerichtet ist, wobei die Elektrode des Kondensators mit der Elektrode des Halbleiterelementes verbunden ist.

6. Bauelement nach einem vorangehenden Anspruch, bei dem die vielschichtige Verdrahtungsschicht so ausgebildet ist, daß eine Polyimid-Schicht und ein dünner Metallfilm als Isolierschicht bzw. leitende Schicht verwendet werden.

## Revendications

1. Dispositif semi-conducteur comprenant :
une plaque isolante (101, 201) ayant une première surface (101b, 201b) sur laquelle un conducteur externe (111, 211) est disposé et une seconde surface (101a, 201a) sur laquelle une couche de connexion est formée et est connectée au conducteur externe par l'intermédiaire d'un trou de passage;
une couche de connexion multicouche (102, 202) formée sur la seconde surface de la plaque isolante et comportant une borne d'électrode connectée électriquement à la couche de connexion de la plaque isolante ;
un élément semi-conducteur (105, 205) disposé de telle sorte qu'une première surface de l'élément semi-conducteur sur laquelle une électrode est formée fait face à la couche de connexion multicouche , ladite électrode étant connectée à la couche de connexion multicouche (102, 202) ; et
un dissipateur thermique (107, 207) fixé sur une seconde surface de l'élément semi-conducteur opposée à la première surface , caractérisé en ce que ledit dispositif semi-conducteur comprend de plus :
un condensateur de réduction de bruit d'alimentation électrique (103, 203) formé sur une plaque de céramique à base d'alumine par une technique de film mince et disposé entre la couche de connexion multicouche et l'élément semi-conducteur ; et
un élément tampon (104, 204) fixé sur une surface du condensateur de réduction de bruit d'alimentation électrique pour empêcher l'élément semi-conducteur d'être endommagé par une pression mécanique lorsque le dissipateur thermique est fixé sur l'élément semi-conducteur.

2. Dispositif selon la revendication 1 , dans lequel ledit élément tampon (104) est disposé entre le condensateur et l'élément semi-conducteur.

3. Dispositif selon la revendication 1 , dans lequel ledit élément tampon (204) est disposé entre la couche de connexion multicouche et le condensateur;

4. Dispositif selon la revendication 1 ou la revendication 2 , dans lequel la couche de connexion multicouche présente une surface sur laquelle une borne d'électrode d'alimentation électrique est formée, le condensateur présentant une seconde surface opposée à sa première surface mentionnée, sur laquelle une électrode est formée, ladite seconde surface du condensateur faisant face à la surface de la couche de connexion multicouche, l'électrode du condensateur étant connectée à la borne d'électrode d'alimentation électrique.

5. Dispositif selon la revendication 1 ou 3,dans lequel le condensateur présente une seconde surface, opposée à sa première surface mentionnée, sur laquelle une électrode est formée , ladite seconde surface faisant face à la première surface de l'élément semi-conducteur , l'électrode du condensateur étant connectée à l'électrode de l'élément semi-conducteur.

6. Dispositif selon l'une quelconque des revendications précédentes , dans lequel la couche de connexion multicouche est formée de telle sorte qu'une couche de polyimide et un film métallique mince sont utilisés , respectivement, en tant que couche isolante et que couche conductrice .
